# EUROPEAN PATENT SPECIFICATION

(11) **EP 1 893 012 B1**
(45) Date of publication and mention of the grant of the patent: **22.04.2009**
(21) Application number: 06015386.3
(22) Date of filing: 24.07.2006
(51) Int. Cl.: H05K 9/00, H01R 12/16

(54) **Fastening element**
Befestigungselement
Elément de fixation

(43) Date of publication of application: 27.02.2008
(73) Proprietor: Harman Becker Automotive Systems GmbH, 76307 Karlsbad (DE)
(72) Inventor: Rieger, Robby, 76307 Karlsbad-Ittersbach (DE)
(74) Representative: Bertsch, Florian Oliver

(56) References cited:
- EP-A2- 0 889 683
- DE-U1- 8 213 627
- DE-U1- 20 316 262
- JP-A- 8 069 826
- US-A- 5 786 989

## Description

The present invention relates to a fastening element, a connection system, and a method for connecting a housing to a printed circuit board.

In many electronic devices a printed circuit board has to be connected to or housed in a housing. Additionally, if the device is sensitive to electromagnetic radiation or emits electromagnetic radiation, for example car radio devices, shieldings have to be attached to the PCB and/or the housing. Releasable connections, for example screwed connections, are preferred, as this simplifies maintenance and repair actions. Several connection methods for connecting a housing, a printed circuit board, and optionally a shielding are known in the art, but they all suffer from various disadvantages.

Soldering the shielding to the printed circuit board and connecting the shielding to the housing has the following disadvantages: First, when connecting the shielding with a self-tapping screw through a hole in the housing and a thread cut by the screw in the shielding, as the shielding plates are normally rather thin, there is a great risk of overwinding the screw due to the low mechanical strength of the thin shielding plate. As an alternative an insert nut can be inserted into the shielding, but this increases the cost of production and complicates the production process. Furthermore, the connection of the printed circuit board to the housing via the shielding is not very reliable, as the shielding might tear due to mechanical loads and vibrations.

Connecting the printed circuit board to the housing via a screw extending through a hole in the printed circuit board into a thread of the housing is only possible if the printed circuit board and the surface of the housing to which the printed circuit board has to be connected to, are in parallel. If the printed circuit board and the surface of the housing are perpendicular in the area where they have to be connected, a threaded protrusion has to be provided at the housing, which increases production costs and makes the production process of the housing more complicated. Furthermore, a separate connection has to be provided for an optional shielding.

DE 82 13 627 discloses a fastening element as defined in the preamble of claim 1.

Moreover, it is common for the above-mentioned connecting methods that they are difficult to be implemented in a completely automated production process.

Therefore, there is a need for providing a fastening element for connecting a housing to a printed circuit board that provides a releasable and reliable connection between a printed circuit board and a housing, which is capable of optionally including the connection to a shielding, and which is capable of being processed automatically by a mounting tool or a robot.

According to the present invention, this object is achieved by a fastening element as defined in claim 1, a connection system as defined in claim 11 and a method for connecting a housing, a shielding an a printed circuit board as defined in claim 17. The dependent claims define preferred and advantageous embodiments of the invention.

According to one aspect of the invention a fastening element for connecting a housing to a printed circuit board is provided. The fastening element comprises a first surface comprising a through hole for receiving a connecting element connecting the fastening element to the housing, at least one first mounting pin extending from the first surface for mounting the fastening element to the printed circuit board. Additionally, a second surface is provided from which a second mounting pin extends for mounting the fastening elements to the printed circuit board, and a third surface connecting the first and the second surfaces. The third surface comprises a planar section providing a grasp surface for a mounting tool or a robot for mounting the fastening elements to the printed circuit board automatically.

The fastening element defined above provides a reliable means for releasably connecting a housing to a printed circuit board, as it provides a through hole for receiving a connecting element, for example a self-tapping screw, which enables a reliable connection between the housing and the fastening element, and furthermore the fastening element provides at least one first mounting pin and a second mounting pin for mounting, for example soldering, the fastening element to the printed circuit board. Due to the planar section of the third surface an automated mounting of the fastening element on the PCB is possible.

According to one embodiment of the present invention the second surface of the fastening element extends substantially oblique to the first surface. The at least one first mounting pin extending from the first surface and the second mounting pin extending from the second surface are extending parallel to each other such that the tips of the pins are lying in one plane.

Such an arrangement of the mounting pins increases the rigidity of the fastening element when the fastening element is mounted on the printed circuit board.

According to another embodiment of the invention the third surface is substantially perpendicular to the first surface and the third surface is substantially parallel to the printed circuit board when the fastening element is mounted on the printed circuit board. Configuring the fastening element like this facilitates an automated mounting of the fastening element with a mounting tool or a robot.

In another embodiment of the invention the fastening element comprises a through hole in the second surface aligned with the through hole of the first surface so that the through hole of the second surface is able to receive the connecting element projecting and extending through the through hole of the first surface. This avoids that a long connecting element abuts against the second surface, so that the designers do not have to take care about the length of the connecting element and larger tolerances of material thicknesses and arrangements of the printed circuit board inside the housing are permissible.

According to another aspect of the invention a connecting system for connecting a printed circuit board to a shielding plate and a housing is provided. The connecting system comprises a housing comprising a through hole for receiving a connecting element, a shielding plate comprising a through hole for receiving the connecting element, and a fastening element as described in any of the embodiments delivered above.

With a connection system as defined above the housing, the shielding plate, and the printed circuit board can be releasably connected within one production step. As the connecting element engages the fastening element, the shielding plate can be attached without applying mechanical forces that could damage the shielding plate. As the fastening element provides a solid receiver for the connecting element and the fastening element is automatically mountable to the printed circuit board, the whole production process can be automatically performed by a manipulator or robot.

According to an embodiment of the invention the connecting system comprises a connecting element comprising one of a rivet, a screw, a thread-forming self-tapping screw, a sheet metal screw, a bolt, and a machine screw.

As the connecting system is able to cooperate with such a wide variety of connecting elements of different kinds, diameters and lengths, the connecting system can be used in many areas and the most appropriate connecting element may be chosen for the connecting systems of a device and therefore the variety of connecting elements within one device can be reduced.

According to another embodiment of the invention the shielding comprises a metal sheet, a plastic sheet, or a multi-layered sheet comprising several metal or plastic sheets. Additionally, the connecting system can be used to electrically connect at least two of the housing, the shielding and the fastening element via the connecting element. This enables, for example, to connect the ground of the printed circuit board with the ground of the housing and the shielding in an easy way. On the other hand the connecting system provides, if the shielding is an isolating shielding, made for example of a plastic sheet, a fixing of isolating shielding plates within the housing, between the printed circuit board and the housing, or between several stacked printed circuit boards.

According to another aspect of the invention a method for connecting a housing, a shielding plate and a printed circuit board is provided. The method comprises the steps of
- mounting a fastening element to the printed circuit board,
- arranging a surface of the housing, the shielding plate and one surface of the fastening element to form a layered structure so that the shielding plate is sandwiched between the surface of the housing and said surface of the fastening element,
- aligning the surface of the housing, the shielding plate and the fastening element so that through holes of the surface of the housing, the shielding plate and the surface of the fastening element form one through hole through the layered structure,
- connecting the surface of the housing, the shielding plate and the fastening element with a connecting element passing through the one through hole of the layered structure.

The fastening element comprises a fastening element as defined above.

This method connects within one production step the housing, the shielding plate, and the printed circuit board. This makes the production process less difficult and enables the production to be performed by a manipulator or a robot. By arranging the shielding plate sandwiched between the surface of the housing and the surface of the fastening element the mechanical load on the shielding plate is reduced compared to a shielding plate which is directly fixed with a screw.

The invention will now be described in more detail with reference to the accompanying drawings, in which:
Fig. 1 shows a perspective view of a fastening element according to the invention;
Fig. 2 shows a side view of the fastening element of Fig. 1 viewed in the direction of arrow A of Fig. 1;
Fig. 3 shows a front view of the fastening element of Fig. 1 viewed from the direction indicated by arrow B in Fig. 1;
Fig. 4 shows a top view of the fastening element of Fig. 1 viewed from a direction indicated by arrow C in Fig. 1;
Fig. 5 shows a connecting system according to the invention.

Now, referring to the drawings, the embodiments of the present invention will be described.

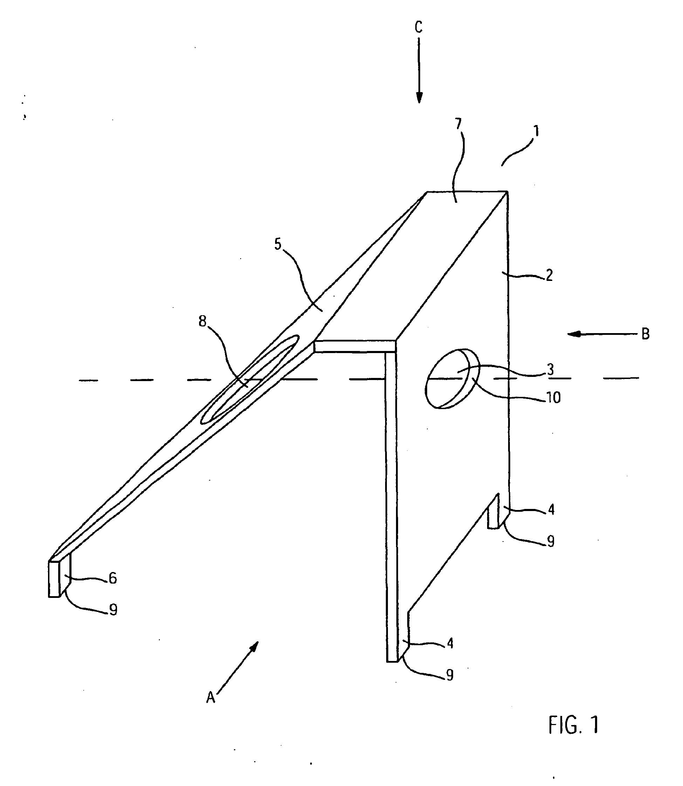

Fig. 1 shows a perspective view of the fastening element 1 comprising a first surface 2 comprising a through hole 3 for receiving a connecting element connecting the fastening element 1 to a housing, which will be described later on. Two first mounting pins 4 extend from the first surface 2 for mounting the fastening element 1 to a printed circuit board (not shown). A second surface 5 is arranged substantially oblique to the first surface 2. A second mounting pin 6 extends from the second surface 5 for mounting the fastening element 1 to the printed circuit board. The two first mounting pins and the second mounting pin of the first surface and the second surface respectively, are extending parallel to each other. A third surface 7 connects the first surface 2 and the second surface 5. The third surface 7 comprises a planar section for providing a grasp or holding surface for a mounting tool mounting the fastening element 1 to the printed circuit board. The second surface 5 comprises a through hole 8 aligned with the through hole 3 of the first surface 2 so that the through hole 8 of the second surface 5 is able to receive the connecting element projecting and extending through the through hole 3 of the first surface 2 as indicated by the dashed line in Fig. 1. The second surface 5 has a triangular shape and the second mounting pin 6 extends from an apex of the triangular-shaped second surface 5. An edge of the triangular-shaped second surface being opposed to the apex is connected with an edge of the third surface 7. The distal ends of the first and second mounting pins have tips 9. The three tips 9 define a plane which is substantially perpendicular to the first surface 2 of the fastening element 1. The third surface 7 is also substantially perpendicular to the first surface 2 and furthermore substantially parallel to the plane defined by the tips 9 and therefore parallel to the printed circuit board when the fastening element 1 is mounted on the printed circuit board.

When mounted on a printed circuit board the fastening element 1 described above provides a solid and reliable fastening for connecting a printed circuit board to a housing. Due to the three mounting pins 4, 6 a reliable connection to the printed circuit board is provided. Together with the printed circuit board the fastening element 1 provides a rigid structure so that the fastening element stands the forces applied during manufacturing, that means during receiving a connecting element in the through hole 3, and in operation, when the electronic device comprising the printed circuit board is mounted for example in a car, where mechanical forces and vibrations are applied to the housing, the fastening element, and the printed circuit board.

Due to the existence of the third surface 7 being substantially parallel to the printed circuit board and providing a grasp surface for a mounting tool the fastening element 1 can easily be mounted to the printed circuit board by a mounting tool or a robot. This reduces the number of production steps and therefore the cost of production.

The through hole 8 of the second surface 5 aligned with the through hole 3 of the first surface 2 enables to use connecting elements that extend through the second surface 5 in a mounted position. This has the following advantages.

First, the number of connecting elements with different lengths can be reduced by using one or a few connecting elements with a standard length and therefore the storage costs can be reduced; and second, longer connecting elements can be used for balancing tolerances of the housing, the printed circuit board, or a shielding plate to be connected with the fastening element.

The through hole 3 of the first surface 2 provides an inner circumferential surface 10 providing an edge engaging an outer surface of the connecting element. The inner circumferential surface 10 can be provided with a thread for receiving a bolt or a machine screw as the connecting element, or the inner circumferential surface 10 is capable of receiving a thread-forming self-tapping screw as a connecting element. Furthermore, the through hole 3 of the first surface 2 can be provided with an insert nut for receiving a bolt or a machine screw as the connecting element. Due to the rigidity of the fastening element 1 various connecting elements, for example bolts, machine screws, thread-forming self-tapping screws, sheet metal screws and even rivets can be used as connecting elements. This gives a user the flexibility for choosing the most appropriate and desired connecting element.

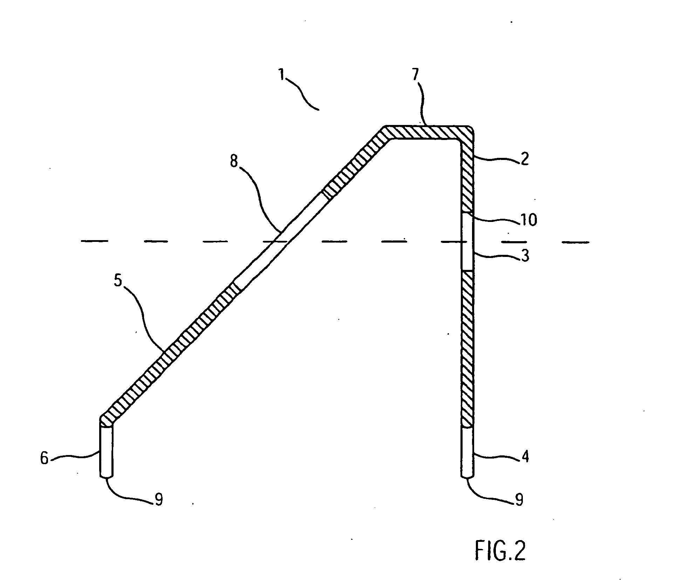

Fig. 2 shows a side view of the fastening element 1 and clarifies the arrangement of the mounting pins 4, 6 in parallel, the alignment of the through hole 3 of the first surface 2 and the through hole 8 of the second surface 5 indicated by the dashed line, the parallel arrangement of the third surface 7 and the plane defined by the tips 9 of the mounting pins 4, 6, and the substantially perpendicular arrangement of the first surface 2 and the third surface 7, and the substantially perpendicular arrangement of the first surface 2 and the plane defined by the tips 9 of the mounting pins 4, 6.

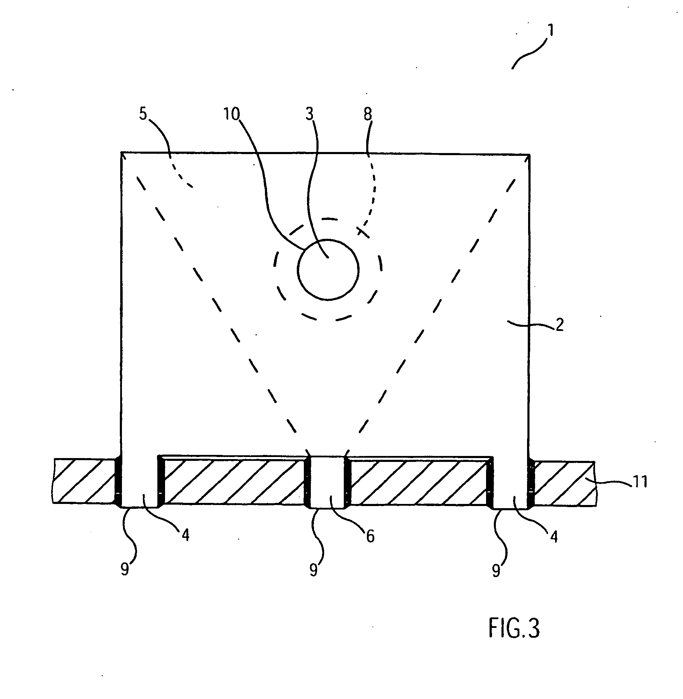

Fig. 3 shows the fastening element 1 of Fig. 1 in a front view viewed in the direction of arrow B of Fig. 1 connected to a printed circuit board 11. The mounting pins 4, 6 are extending through holes of the printed circuit board 11 and can be fixed to the printed circuit board by for example press fitting or soldering. In this view the second surface 5 and through hole 8 are hidden behind the first surface 2, but indicated by dashed lines in Fig. 3. As can be seen in Fig. 3, the diameter of the through hole 8 of the second surface 5 is larger than the diameter of the through hole 3 of the first surface 2. This enables, when the connecting element extends through the through hole 8 of the second surface 5, the connecting element not to abut against the second surface 5, even if it is only approximately perpendicular inserted in through hole 3 of the first surface 2.

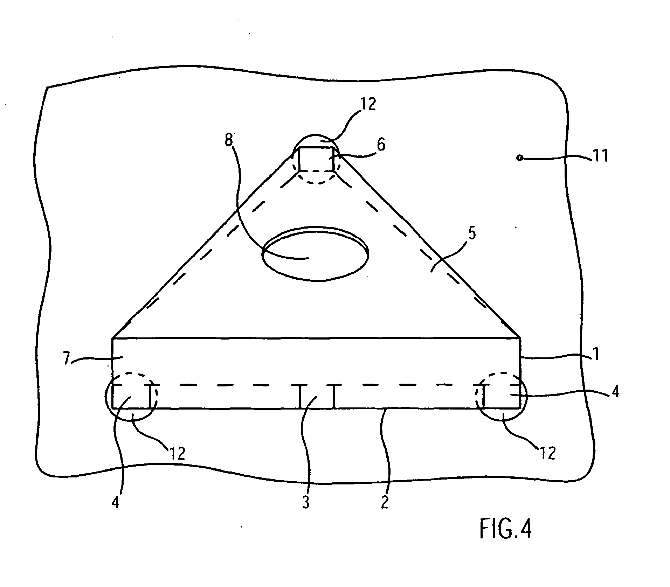

Fig. 4 is a top view of the fastening element 1, viewed from the direction indicated by arrow C in Fig. 1. The fastening element 1 is connected to the printed circuit board 11 via the first mounting pins 4 and the second mounting pin 6 extending through holes 12 in the printed circuit board 11. By connecting the fastening element 1 to the printed circuit board 11 via three mounting pins 4, 6 defining a plane the fastening element 1 is able to impart forces in all directions received from the connecting element received in the through hole 3 of the first surface 2 to the printed circuit board 11. This assures a reliable and rigid connection of a printed circuit board to a housing.

As the third surface 7 is substantially parallel to the printed circuit board 11, the fastening element can be grasped by a mounting tool and automatically mounted to the printed circuit board 11. In that the fastening element 1 is connected to the printed circuit board 11 via three mounting pins only, only a low positioning accuracy of the mounting tool is required.

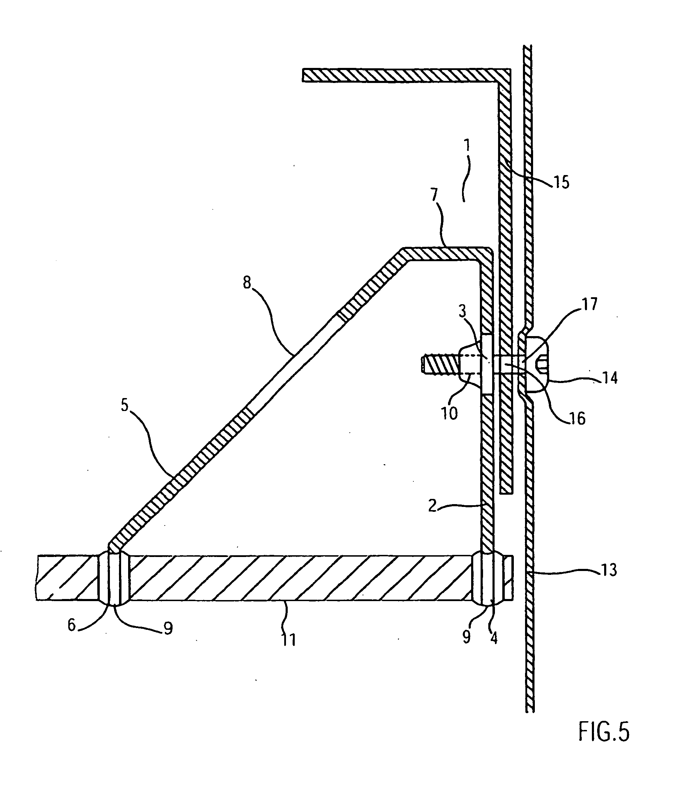

Fig. 5 shows a connecting system for connecting a printed circuit board 11 to a shielding plate 15 and a housing 13. A fastening element 1 as described above is connected with mounting pins 4, 6 to the printed circuit board 11. A first surface 2 of the fastening element 1 provides a through hole 3 for receiving a connecting element 14. The shielding plate 15 provides a through hole 16 for receiving the connecting element 14. A surface of the housing 13 comprises a through hole 17 for receiving the connecting element 14. The connecting element 14 is a screw, for example a thread-forming self-tapping screw, a sheet metal screw, a bolt, or a machine screw. After aligning the through hole 17 of the surface of the housing 13 with the through hole 16 of the shielding plate 15 and the through hole 3 of the first surface 2 of the fastening element 1 the connecting element 14 is inserted through the through holes 17, 16 and 3. The through hole 3 of the first surface 2 provides an inner circumferential surface 10 providing an edge engaging the outer surface of the connecting element 14. This engagement may be accomplished either by forming a thread in the through hole 3 before mounting the fastening element to the printed circuit board 11, or by using a thread-forming self-tapping screw as the connecting element 14 and forming a thread in the through hole 3 of the first surface during rotatively inserting the connecting element in the through hole 3. The depicted connecting system provides a reliable connection between the printed circuit board 11 and the surface of the housing 13. Additionally, the shielding plate 15 is fixed to the printed circuit board and housing respectively. By sandwiching the shielding plate between the first surface 2 and the surface of the housing 13 the shielding plate 15 is clamped with the connecting element 14 between the first surface 2 and the surface of the housing 13. Clamping of the shielding plate enables a secure fixing of the shielding plate 15 without applying large forces to the shielding plate as they would for example occur if the shielding plate would be connected to a surface of the housing by a thread-forming self-tapping screw forming a thread in the circumferential surface of the through hole 16 of the shielding plate 15. Therefore, also thin or sensitive materials can be used as shielding plates, for example thin metal sheets, plastic sheets, coated plastic sheets or multi-layered sheets comprising several metal or plastic sheets.

As the fastening element 1 mounted to the printed circuit board 11 provides a high rigidity, the connecting element 14 can be inserted and screwed in by a mounting tool or a robot. As the shielding plate 15 is connected to the printed circuit board 11 together with the surface of the housing 13 with one connecting element 14 within one production step the number of production steps is reduced and thus the cost of production reduced. As the fastening element 1 and the connecting element 14 are made of metal, an electrical connection can be provided between the housing, the shielding and/or the printed circuit board. Therefore, this connecting system provides not only a mechanical connection between the printed circuit board 11 and the housing 13, but also provides, if desired, an electrical connection between the printed circuit board 11, the shielding plate 15, and the housing 13, for example for a ground connection of the three components.

The fastening element 1 provides a grasping surface on its third surface 7. Therefore, the production steps of mounting the fastening element 1 to the printed circuit board, arranging the shielding plate 15 and the surface of the housing 13 substantially perpendicular to the printed circuit board 11, aligning the through holes 3, 16, 17 of the first surface 2 of the fastening element 1, the shielding plate 15, and the surface of the housing 13, respectively, and inserting the connecting element 14 can be performed automated by a manipulator or a robot.

## Claims

1. Fastening element for connecting at least a housing (13) to a printed circuit board (11), comprising:
- a first surface (2) comprising a through hole (3) for receiving a connecting element (14) connecting the fastening element (1) to the housing (13), and
- a second surface (5) from which a second mounting pin (6) extends for mounting the fastening element (1) to the printed circuit board (11),
**characterized in that**
the fastening element further comprises:
- at least one first mounting pin (4) extending from the first surface (2) for mounting the fastening element (1) to the printed circuit board (11), and
- a third surface (7) connecting the first (2) and the second surfaces (5), the third surface (7) comprising a planar section providing a grasp surface for a mounting tool mounting the fastening element (1) to the printed circuit board (11).

2. Fastening element according to claim 1, wherein the second surface (5) extends substantially oblique to the first surface (2), the at least one first (4) and the second mounting pins (6) of both surfaces (2,5) extending parallel to each other.

3. Fastening element according to claim 1 or 2, wherein the third surface (7) is substantially perpendicular to the first surface (2).

4. Fastening element according to any of the preceding claims, wherein the third surface (7) is substantially parallel to the printed circuit board (11) when the fastening element (1) is mounted to the printed circuit board (11).

5. Fastening element according to any of the preceding claims, wherein the second surface (5) has a triangular shape, the second mounting pin (6) extending from an apex of the triangular-shaped second surface (5) and an edge of the triangular shaped second surface being opposed to the apex is connected with an edge of the third surface (7).

6. Fastening element according to any of the preceding claims, wherein the second surface (5) comprises a through hole (8) aligned with the through hole (3) of the first surface (2) so that the through hole (8) of the second surface (5) is able to receive the connecting element (14) projecting and extending through the through hole (3) of the first surface (2).

7. Fastening element according to any of the preceding claims, wherein two first mounting pins (4) and the second mounting pin (6) of the fastening element (1) are arranged substantially in parallel and such that tips (9) of the pins (4,6) are lying in a plane substantially perpendicular to the first surface (2) of the fastening element (1).

8. Fastening element according to any of the preceding claims, wherein the through hole (3) of the first surface (2) provides an inner circumferential surface (10) providing an edge engaging the outer surface of the connecting element (14).

9. Fastening element according to claim 8, wherein the inner circumferential surface (10) of the through hole (3) of the first surface (2) is provided with a thread.

10. Fastening element according to claim 8, wherein the edge of the inner circumferential surface (10) of the through hole (3) of the first surface (2) is capable of receiving a thread-forming self-tapping screw.

11. Connecting system for connecting a printed circuit board (11) to a shielding plate (15) and a housing (13) comprising:
- a housing (13) comprising a through hole (17) for receiving a connecting element (14),
- a shielding plate (15) comprising a through hole (16) for receiving the connecting element (14), and
- a fastening element (1),
**characterized in that**
the fastening element (1) comprises a fastening element (1) as defined in any one of claims 1-8.

12. Connecting system according to claim 11, wherein at least two of the housing (13), the shielding plate (15), and the fastening element (1) are electrically connected via the connecting element (14).

13. Connecting system according to claim 11 or 12, wherein the connecting element (14) comprises one of a rivet, a screw, a thread-forming self-tapping screw, a sheet metal screw, a bolt, and a machine screw.

14. Connecting system according to any one of claims 11-13, wherein the shielding plate (15) comprises a metal sheet, a plastic sheet, or a multi layered sheet comprising several metal or plastic sheets.

15. Connecting system according to any one of claims 11-14, wherein the shielding plate (15) is sandwiched between the housing (13) and the fastening element (1).

16. Connecting system according to any one of claims 11-15, wherein the mounting pins (4,6) of the fastening element (1) are fixed at the printed circuit board (11) by soldering.

17. A method for connecting a housing (13), a shielding plate (15) and a printed circuit board (11) comprising the steps of
- mounting a fastening element (1) to the printed circuit board (11),
- arranging a surface of the housing (13), the shielding plate (15) and one surface (2) of the fastening element (1) to form a layered structure so that the shielding plate (15) is sandwiched between the surface of the housing (13) and said surface (2) of the fastening element (1),
- aligning the surface of the housing (13), the shielding plate (15) and the fastening element (1) so that through holes (3, 16, 17) of the surface of the housing (13), the shielding plate (15) and the surface (2) of the fastening element (1) form one through hole through the layered structure,
- connecting the surface of the housing (13), the shielding plate (15) and the fastening element (1) with a connecting element (14) passing through the one through hole of the layered structure,
wherein
the fastening element (1) comprises a fastening element (1) as defined in any one of claims 1-10.

18. A method as defined in claim 17,
wherein the fastening element (1) is mounted to the printed circuit board (11) such that the one surface (2) of the fastening element (1), the shielding plate (15), and the surface of the housing (13) are perpendicular to the printed circuit board (11).

19. A method as defined in claim 17 or claim 18,
wherein at least three mounting pins (4,6) of the fastening element (1) for mounting the fastening element (1) to the printed circuit board (11) are arranged substantially in parallel and such that tips (9) of the pins (4,6) are lying in a plane substantially perpendicular to the one surface (2) of the fastening element (1).

20. A method as defined in any one of claims 17-19,
additionally comprising the step of soldering the fastening element (1) to the printed circuit board (11) after the step of the mounting of the fastening element (1) to the printed circuit board (11).

21. A method as defined in any one of claims 17-20,
wherein the connecting element (14) comprises a screw and the step of connecting the surface of the housing (13), the shielding plate (15) and the fastening element (1) comprises the screwing of the screw through the surface of the housing (13), the shielding plate (15) and the one surface (2) of fastening element (1).

22. A method as defined in any one of claims 17 to 21,
**characterized in that** at least one of the steps of the mounting, arranging, aligning and connecting is performed automatically by a manipulator or a robot.

## Patentansprüche

1. Befestigungselement zum Verbinden von mindestens einem Gehäuse (13) mit einer bedruckten Leiterplatte (11), umfassend:
- eine erste Fläche (2), die ein Durchgangsloch (3) zum Aufnehmen eines Verbindungselements (14), das das Befestigungselement (1) mit dem Gehäuse (13) verbindet, umfasst, und
- eine zweite Fläche (5), von welcher sich ein zweiter Befestigungsstift (6) zum Anbringen des Befestigungselements (1) an der gedruckten Leiterplatte (11) erstreckt,
**dadurch gekennzeichnet, dass**
das Befestigungselement des Weiteren umfasst:
- mindestens einen ersten Befestigungsstift (4), der sich von der ersten Fläche (2) erstreckt, zum Anbringen des Befestigungselements (1) an der gedruckten Leiterplatte (11), und
- eine dritte Fläche (7), die die erste (2) und die zweite Fläche (5) verbindet, wobei die dritte Fläche (7) einen ebenen Abschnitt umfasst, der eine Greiffläche für ein Montagewerkzeug bereitstellt, das das Befestigungselement (1) an der gedruckten Leiterplatte (11) anbringt.

2. Befestigungselement nach Anspruch 1, wobei sich die zweite Fläche (5) im Wesentlichen schief zu der ersten Fläche (2) erstreckt, wobei sich der mindestens eine erste (4) und der zweite Befestigungsstift (6) von beiden Flächen (2, 5) parallel zueinander erstrecken.

3. Befestigungselement nach Anspruch 1 oder 2, wobei die dritte Fläche (7) im Wesentlichen senkrecht zu der ersten Fläche (2) ist.

4. Befestigungselement nach einem der vorstehenden Ansprüche, wobei die dritte Fläche (7) im Wesentlichen parallel zu der gedruckten Leiterplatte (11) ist, wenn das Befestigungselement (1) an der bedruckten Leiterplatte (11) angebracht ist.

5. Befestigungselement nach einem der vorstehenden Ansprüche, wobei die zweite Fläche (5) eine dreieckige Form aufweist, wobei sich der zweite Befestigungsstift (6) von einem Scheitel der dreieckförmigen zweiten Fläche (5) erstreckt und eine Kante der dreieckförmigen zweiten Fläche, die dem Scheitel gegenüberliegt, mit einer Kante der dritten Fläche (7) verbunden ist.

6. Befestigungselement nach einem der vorstehenden Ansprüche, wobei die zweite Fläche (5) ein Durchgangsloch (8) umfasst, das mit dem Durchgangsloch (3) der ersten Fläche (2) ausgerichtet ist, so dass das Durchgangsloch (8) der zweiten Fläche (5) das Verbindungselement (14), das sich durch das Durchgangsloch (3) der ersten Fläche (2) erstreckt und von diesem hervorsteht, aufnehmen kann.

7. Befestigungselement nach einem der vorstehenden Ansprüche, wobei die zwei ersten Befestigungsstifte (4) und der zweite Befestigungsstift (6) des Befestigungselements (1) im Wesentlichen parallel und derart angeordnet sind, dass Spitzen (9) der Stifte (4, 6) in einer Ebene, die im Wesentlichen senkrecht zu der ersten Fläche (2) des Befestigungselements (1) ist, liegen.

8. Befestigungselement nach einem der vorstehenden Ansprüche, wobei das Durchgangsloch (3) der ersten Fläche (2) eine innere Umfangsfläche (10) bereitstellt, die eine Kante bereitstellt, die in die äußere Fläche des Verbindungselements (14) eingreift.

9. Befestigungselement nach Anspruch 8, wobei die innere Umfangsfläche (10) des Durchgangslochs (3) der ersten Fläche (2) mit einem Gewinde versehen ist.

10. Befestigungselement nach Anspruch 8, wobei die Kante der inneren Umfangsfläche (10) des Durchgangslochs (3) der ersten Fläche (2) geeignet ist, eine Gewinde bildende, selbstschneidende Schraube aufzunehmen.

11. Verbindungssystem zum Verbinden einer gedruckten Leiterplatte (11) mit einer Abschirmplatte (15) und einem Gehäuse (13) umfassend:
- ein Gehäuse (13), das ein Durchgangsloch (17) zum Aufnehmen eines Verbindungselements (14) umfasst,
- eine Abschirmplatte (15), die ein Durchgangsloch (16) zum Aufnehmen des Verbindungselements (14) umfasst, und
- ein Befestigungselement (1),
**dadurch gekennzeichnet, dass**
das Befestigungselement (1) ein Befestigungselement (1) wie in einem der Ansprüche 1-8 definiert umfasst.

12. Verbindungssystem nach Anspruch 11, wobei mindestens zwei von dem Gehäuse (13), der Abschirmplatte (15), und dem Befestigungselement (1) mittels des Verbindungselements (14) elektrisch verbunden sind.

13. Verbindungssystem nach Anspruch 11 oder 12, wobei das Verbindungselement (14) einen Niet, eine Schraube, eine Gewinde bildende, selbstschneidende Schraube, eine Blechschraube, einen Bolzen, oder eine Maschinenschraube umfasst.

14. Verbindungssystem nach einem der Ansprüche 11-13, wobei die Abschirmplatte (15) ein Metallblech, eine Kunststoffplatte, oder eine mehrlagige Platte, die mehrere Metall- oder Kunststoffplatten umfasst, umfasst.

15. Verbindungssystem nach einem der Ansprüche 11-14, wobei die Abschirmplatte (15) zwischen dem Gehäuse (13) und dem Befestigungselement (1) angeordnet ist.

16. Verbindungssystem nach einem der Ansprüche 11-15, wobei die Befestigungsstifte (4, 6) des Befestigungselements (1) an der gedruckten Leiterplatte (11) durch Löten befestigt werden.

17. Verfahren zum Verbinden eines Gehäuses (13), einer Abschirmplatte (15) und einer gedruckten Leiterplatte (11), die folgenden Schritte umfassend
- Anbringen eines Befestigungselements (1) auf der gedruckten Leiterplatte (11),
- Anordnen einer Fläche des Gehäuses (13), der Abschirmplatte (15) und einer Fläche (2) des Befestigungselements (1), um eine geschichtete Struktur zu bilden, so dass die Abschirmplatte (15) zwischen der Fläche des Gehäuses (13) und der Fläche (2) des Befestigungselements (1) angeordnet ist,
- Ausrichten der Fläche des Gehäuses (13), der Abschirmplatte (15) und des Befestigungselements (1) so dass Durchgangslöcher (3, 16, 17) der Fläche des Gehäuses (13), der Abschirmplatte (15) und der Fläche (2) des Befestigungselements (1) ein Durchgangsloch durch die geschichtete Struktur bilden,
- Verbinden der Fläche des Gehäuses (13), der Abschirmplatte (15) und des Befestigungselements (1) mit einem Verbindungselement (14), das durch das eine Durchgangsloch der geschichteten Struktur hindurchtritt,
wobei
das Befestigungselement (1) ein Befestigungselement (1) wie in einem der Ansprüche 1-10 definiert umfasst.

18. Verfahren nach Anspruch 17, wobei das Befestigungselement (1) an der gedruckten Leiterplatte (11) derart angebracht ist, dass die eine Fläche (2) des Befestigungselements (1), die Abschirmplatte (15), und die Fläche des Gehäuses (13) senkrecht zu der gedruckten Leiterplatte (11) sind.

19. Verfahren nach Anspruch 17 oder Anspruch 18, wobei mindestens drei Befestigungsstifte (4, 6) des Befestigungselements (1) zum Anbringen des Befestigungselements (1) an der gedruckten Leiterplatte (11) im Wesentlichen parallel und derart angeordnet sind, dass Spitzen (9) der Stifte (4, 6) in einer Ebene im Wesentlichen senkrecht zu der einen Fläche (2) des Befestigungselements (1) liegen.

20. Verfahren nach einem der Ansprüche 17-19, zusätzlich den Schritt eines Lötens des Befestigungselements (1) an die gedruckte Leiterplatte (11) nach dem Schritt des Anbringens des Befestigungselements (1) an der gedruckten Leiterplatte (11) umfassend.

21. Verfahren nach einem der Ansprüche 17-20, wobei das Verbindungselement (14) eine Schraube umfasst und wobei der Schritt des Verbindens der Fläche des Gehäuses (13), der Abschirmplatte (15) und des Befestigungselements (1) das Schrauben der Schraube durch die Fläche des Gehäuses (13), die Abschirmplatte (15) und die eine Fläche (2) des Befestigungselements (1) umfasst.

22. Verfahren nach einem der Ansprüche 17-21, **dadurch gekennzeichnet, dass** mindestens einer der Schritte des Befestigens, des Anordnens, des Ausrichtens, und des Verbindens automatisch durch einen Manipulator oder einen Roboter durchgeführt wird.

## Revendications

1. Elément de fixation pour relier au moins un boîtier (13) à une carte à circuits imprimés (11), comprenant:
- une première surface (2) comportant un trou de passage (3) pour recevoir un élément de liaison (14) reliant l'élément de fixation (1) au boîtier (13), et
- une deuxième surface (5), de laquelle s'étend une deuxième goupille de montage (6) pour monter l'élément de fixation (1) sur la carte à circuits imprimés (11),
**caractérisé en ce que** l'élément de fixation comprend en outre:
- au moins une premier goupille de montage (4) s'étendant de la première surface (2) pour monter l'élément de fixation (1) sur la carte à circuits imprimés (11), et
- une troisième surface (7) reliant les première (2) et deuxième surfaces (5), la troisième surface (7) comprenant une section plane fournissant une surface de préhension pour un outillage de montage montant l'élément de fixation (1) sur la carte à circuits imprimés (11).

2. Elément de fixation selon la revendication 1, dans lequel la deuxième surface (5) s'étend essentiellement de manière oblique par rapport à la première surface (2), la au moins une première (4) et les deuxièmes goupilles de montage (6) des deux surfaces (2, 5) s'étendant parallèlement les unes par rapport aux autres.

3. Elément de fixation selon la revendication 1 ou 2, dans lequel la troisième surface (7) est essentiellement perpendiculaire à la première surface (2).

4. Elément de fixation selon l'une quelconque des revendications précédentes, dans lequel la troisième surface (7) est essentiellement parallèle à la carte à circuits imprimés (11) lorsque l'élément de fixation (1) est monté sur la carte à circuits imprimés (11).

5. Elément de fixation selon l'une quelconque des revendications précédentes, dans lequel la deuxième surface (5) a une forme triangulaire, la deuxième goupille de montage (6) s'étendant d'un sommet de la deuxième surface (5) triangulaire, et un bord de la deuxième surface triangulaire opposé au sommet étant relié à un bord de la troisième surface (7).

6. Elément de fixation selon l'une quelconque des revendications précédentes, dans lequel la deuxième surface (5) comporte un trou de passage (8) en alignement avec le trou de passage (3) de la première surface (2), de sorte que le trou de passage (8) de la deuxième surface (5) est apte à recevoir l'élément de liaison (14) saillissant et s'étendant à travers le trou de passage (3) de la première surface (2).

7. Elément de fixation selon l'une quelconque des revendications précédentes, dans lequel deux premières goupilles de montage (4) et la deuxième goupille de montage (6) de l'élément de fixation (1) sont disposées essentiellement en parallèle et de sorte que les pointes (9) des goupilles (4, 6) se trouvent dans un plan essentiellement perpendiculaire à la première surface (2) de l'élément de fixation (1).

8. Elément de fixation selon l'une quelconque des revendications précédentes, dans lequel le trou de passage (3) de la première surface (2) donne une surface (10) intérieure circonférentielle fournissant un bord en prise avec la surface extérieure de l'élément de liaison (14).

9. Elément de fixation selon la revendication 8, dans lequel la surface (10) intérieure circonférentielle du trou de passage (3) de la première surface (2) est pourvue d'un filetage.

10. Elément de fixation selon la revendication 8, dans lequel le bord de la surface (10) intérieure circonférentielle du trou de passage (3) de la première surface (2) est adapté à recevoir une vis taraudeuse.

11. Système de liaison pour relier une carte à circuits imprimés (11) à une plaque de blindage (15) et à un boîtier (13), comportant:
- un boîtier (13) comprenant un trou de passage (17) pour recevoir un élément de liaison (14),
- une plaque de blindage (15) comprenant un trou de passage (16) pour recevoir l'élément de liaison (14), et
- un élément de fixation (1),
**caractérisé en ce que** l'élément de fixation (1) comprend un élément de fixation (1) tel que défini dans l'une quelconque des revendications 1 à 8.

12. Système de liaison selon la revendication 11, dans lequel au moins deux parmi le boîtier (13), la plaque de blindage (15), et l'élément de fixation (1) sont reliés électriquement par l'intermédiaire de l'élément de liaison (14).

13. Système de liaison selon la revendication 11 ou 12, dans lequel l'élément de liaison (14) comporte l'un parmi un rivet, une vis, une vis taraudeuse, une vis à tôle, un boulon et une vis mécanique.

14. Système de liaison selon l'une quelconque des revendications 11 à 13, dans lequel la plaque de blindage (15) comporte une tôle, une feuille en matière plastique, ou une feuille multicouches comportant plusieurs tôles ou feuilles en matière plastique.

15. Système de liaison selon l'une quelconque des revendications 11 à 14, dans lequel la plaque de blindage (15) est prise en sandwich entre le boîtier (13) et l'élément de fixation (1).

16. Système de liaison selon l'une quelconque des revendications 11 à 15, dans lequel les goupilles de montage (4, 6) de l'élément de fixation (1) sont fixées sur la carte à circuits imprimés (11) par soudage.

17. Procédé pour relier un boîtier (13), une plaque de blindage (15) et une carte à circuits imprimés (11), comprenant les étapes de
- monter un élément de fixation (1) sur la carte à circuits imprimés (11),
- disposer une surface du boîtier (13), la plaque de blindage (15) et une surface (2) de l'élément de fixation (1) de manière à former une structure en couches telle que la plaque de blindage (15) est prise en sandwich entre la surface du boîtier (13) et ladite surface (2) de l'élément de fixation (1),
- aligner la surface du boîtier (13), la plaque de blindage (15) et l'élément de fixation (1) de telle manière que des trous de passage (3, 16, 17) de la surface du boîtier (13), de la plaque de blindage (15) et de la surface (2) de l'élément de fixation (1) forment un trou de passage à travers la structure en couches,
- relier la surface du boîtier (13), la plaque de blindage (15) et l'élément de fixation (1) avec un élément de liaison (14) passant par ledit trou de passage de la structure en couches,
dans lequel
l'élément de fixation (1) comporte un élément de fixation (1) tel que défini dans l'une quelconque des revendications 1 à 10.

18. Procédé tel que défini dans la revendication 17, dans lequel l'élément de fixation (1) est monté sur la carte à circuits imprimés (11) de telle manière que ladite surface (2) de l'élément de fixation (1), la plaque de blindage (15), et la surface du boîtier (13) sont perpendiculaires à la carte à circuits imprimés (11).

19. Procédé tel que défini dans la revendication 17 ou 18, dans lequel au moins trois goupilles de montage (4, 6) de l'élément de fixation (1) pour monter l'élément de fixation (1) sur la carte à circuits imprimés (11) sont disposées essentiellement en parallèle et de telle manière que les pointes (9) des goupilles (4, 6) sont situées dans un plan essentiellement perpendiculaire à ladite surface (2) de l'élément de fixation (1).

20. Procédé tel que défini dans l'une quelconque des revendications 17 à 19, comportant en outre l'étape de soudage de l'élément de fixation (1) sur la carte à circuits imprimés (11) après l'étape de montage de l'élément de fixation (1) sur la carte à circuits imprimés (11).

21. Procédé tel que défini dans l'une quelconque des revendications 17 à 20, dans lequel l'élément de liaison (14) comporte une vis, et l'étape de relier la surface du boîtier (13), la plaque de blindage (15) et l'élément de fixation (1) comporte le vissage de la vis à travers la surface du boîtier (13), la plaque de blindage (15) et ladite surface (2) de l'élément de fixation (1).

22. Procédé tel que défini dans l'une quelconque des revendications 17 à 21, **caractérisée en ce qu'**au moins l'une des étapes de montage, de disposition, d'alignement et de liaison est effectuée automatiquement par un manipulateur ou un robot.
